Europäisches Patentamt

European Patent Office

Office européen des brevets

(19)

(11) Veröffentlichungsnummer : **0 129 698**
**B1**

(12) **EUROPÄISCHE PATENTSCHRIFT**

(45) Veröffentlichungstag der Patentschrift :
**11.11.87**

(21) Anmeldenummer : **84105655.9**

(22) Anmeldetag : **18.05.84**

(51) Int. Cl.⁴ : **C 25 D 13/08**, C 08 G 73/06,
**H 01 B 1/12**

(54) **Verfahren zur Herstellung von Polypyrrolen und nach diesem Verfahren erhaltene filmförmige Produkte.**

(30) Priorität : **25.05.83 DE 3318857**

(43) Veröffentlichungstag der Anmeldung :
**02.01.85 Patentblatt 85/01**

(45) Bekanntmachung des Hinweises auf die Patenterteilung : **11.11.87 Patentblatt 87/46**

(84) Benannte Vertragsstaaten :
**BE DE FR GB NL**

(56) Entgegenhaltungen :
**EP-A- 0 055 358**
**EP-A- 0 129 070**
**US-A- 3 574 072**

(73) Patentinhaber : **BASF Aktiengesellschaft**
**Carl-Bosch-Strasse 38**
**D-6700 Ludwigshafen (DE)**

(72) Erfinder : **Naarmann, Herbert, Dr.**
**Haardtblick 15**
**D-6719 Wattenheim (DE)**
Erfinder : **Nickl, Johann, Dr.**
**Paray-le-Monial-Strasse 9**
**D-6702 Bad Dürkheim (DE)**
Erfinder : **Köhler, Gernot, Dr.**
**Berner Weg 32**
**D-6700 Ludwigshafen (DE)**

**0 129 698**

**Beschreibung**

Die Erfindung betrifft ein Verfahren zur Herstellung von Polypyrrolen durch anodische Oxidation, von Pyrrol oder Mischungen von Pyrrol mit anderen Comonomeren in einem wäßrigen Elektrolyt-Lösungsmittel in Gegenwart von Leitsalzen unter Abscheiden der Polypyrrole an der vorzugsweise flächig ausgebildeten Anode.

Es ist bekannt, filmförmige Polymere von Pyrrolen durch anodische Oxidation von Pyrrol oder substituierten Pyrrolen in einem polaren, organischen Elektrolyt-Lösungsmittel in Gegenwart von Leitsalzen herzustellen. Die so erhaltenen Polypyrrol-Filme haben eine hohe elektrische Leitfähigkeit bis zu etwa $10^2\,\Omega^{-1}\,cm^{-1}$ (vgl. z. B. J.C.S. Chem. Comm. 1979, S. 635 ; J.C.S. Chem. Comm. 1979, S. 854 oder DE-A 30 49 551). Nachteilig an diesem Verfahren ist jedoch der Einsatz von organischen Lösungsmitteln, z. B. Acetonitril, auch wenn erwähnt ist, daß geringe Mengen an Wasser, beispielsweise bis zu 3 Gew.%, dem Elektrolyt-Lösungsmittel zur Erhöhung der elektrischen Leitfähigkeit zugesetzt werden können.

In der US-PS 3 574 072 wird ebenfalls die elektrochemische Polymerisation von 5- und 6-Ring-Heterocyclen beschrieben. Die Elektrolyse findet dabei in einem organischen Lösungsmittel und einem alkalischen Medium, insbesondere einem wäßrig-alkalischen Medium, statt. Nach den Beispielen der US-PS 3 574 072 liegt der Anteil des Wassers im Elektrolyt-Lösungsmittel nicht über 25 Gew.%, bezogen auf das Elektrolyt-Lösungsmittel. Versuche, den Wasseranteil im Elektrolyt-Lösungsmittel zu Lasten des organischen Lösungsmittels zu erhöhen bzw. das organische Lösungsmittel vollständig durch Wasser zu ersetzen, führten nur zu minderwertigen Produkten, insbesondere konnten keine vernünftigen zusammenhängenden Polymerfilme erhalten werden.

Die Polypyrrole haben in jüngster Zeit als elektrisch hochleitfähige Polymersysteme besonderes Interesse gefunden. Für ihre Anwendung in der Elektrotechnik, bei Halbleiter-Bauteilen, Schaltern, Abschirmmaterialien oder Solarzellen ist es häufig von Vorteil, wenn die Polypyrrole in Form von Filmen vorliegen und zum Einsatz gelangen können.

Aufgabe der vorliegenden Erfindung war es, ein Verfahren zur Herstellung von Polypyrrolen aufzuzeigen, welches bei einfacher und leichter Durchführbarkeit in überwiegend wäßrigen Systemen, insbesondere Wasser selber, unter weitgehendem bzw. vollkommenem Verzicht auf den Einsatz von organischen Lösungsmitteln ausgeführt werden kann und das es gestattet, gezielt und reproduzierbar elektrisch hochleitfähige Polypyrrol-Filme mit guten mechanischen Eigenschaften herzustellen.

Es wurde überraschend gefunden, daß diese Aufgabe durch ein Verfahren gelöst wird, bei dem man Pyrrol gegebenenfalls zusammen mit Comonomeren in einem überwiegend wäßrigen Elektrolyt-Lösungsmittel in Gegenwart von aromatischen Sulfonsäuren und/oder deren Salzen als Leitsalzen elektrochemisch oxidiert und polymerisiert.

Gegenstand der Erfindung ist demzufolge ein Verfahren zur Herstellung von Polypyrrolen durch anodische Oxidation, von Pyrrol oder Pyrrol-Comonomer-Mischungen in einem wasserenthaltenden Elektrolyt-Lösungsmittel in Gegenwart von Leitsalzen unter Abscheiden der Polypyrrole an der vorzugsweise flächig ausgebildeten Anode, welches dadurch gekennzeichnet ist, daß man die anodische Oxidation in einem wäßrigen Elektrolyt-Lösungsmittel durchführt, das zu mindestens 50 Gew.-%, vorzugsweise zu mindestens 80 Gew.-%, aus Wasser besteht, und Sulfonsäuren und/oder Salzen der Sulfonsäuren des Benzol, kondensierter aromatischer Kohlenwasserstoffe, mehrkerniger Chinone, linear verknüpfter nicht kondensierter Oligo- oder Polyphenyle als Leitsalz enthält, wobei die vorgenannten aromatischen Grundverbindungen zusätzlich ein oder mehrere Halogen-, Hydroxyl-, Nitro-, unsubstituierte oder substituierte Amino-, Alkoxy- oder Carboxylsubstituenten aufweisen können.

Auch wenn Salze von aromatischen Sulfonsäuren bei der elektrochemischen Polymerisation von Pyrrol in organischen Elektrolyt-Lösungsmitteln schon als Leitsalze Einsatz gefunden haben (vgl. z. B. DE-A 30 49 551), so war es doch äußerst überraschend, daß bei der Verwendung von Salzen aromatischen Sulfonsäuren bei der elektrochemischen Polymerisation von Pyrrol in Wasser elektrisch hochleitfähige Polymerfilme hoher Qualität und mit guten mechanischen Eigenschaften ohne Zusatz irgendwelcher Hilfsstoffe, z. B. Dispergiermittel, erhalten werden konnten. Dies gilt umso mehr, als die anderen üblichen und auch bevorzugten Leitsalze für die elektrochemische Polymerisation von Pyrrol in organischen Lösungsmitteln bei der Reaktionsführung in überwiegend wäßrigen Elektrolyt-Systemen nur zu völlig unzureichenden Produkten führen oder aber beispielsweise zusammen mit Dispergiermitteln eingesetzt werden müssen, wenn man zu Polymerfilmen gelangen will. Die erfindungsgemäß hergestellten Polypyrrol-Filme sind in ihren Eigenschaften anderen, auf elektrochemischem Wege in wäßrigen Elektrolyt-Systemen hergestellten Polypyrrolen unerwarteterweise weit überlegen. Das erfindungsgemäße Verfahren erlaubt in einfacher und reproduzierbarer Weise die Herstellung von Polypyrrol-Filmen in jeder gewünschten Größe und Dicke, wobei die erhaltenen Produkte bereits in aller Regel elektrisch hochleitfähig sind und elektrische Leitfähigkeiten im allgemeinen über $10^\circ\,\Omega^{-1}\,cm^{-1}$ zeigen.

Als Monomeres wird in dem erfindungsgemäßen Verfahren vorzugsweise Pyrrol alleine eingesetzt. Es können jedoch auch Mischungen von Pyrrol mit Comonomeren zum Einsatz gelangen, wobei der Comonomer-Anteil vorzugsweise nicht über 25 Gew.%, bezogen auf die Gesamtmenge an Monomeren, liegen sollte. Beispielsweise beträgt der Comonomer-Anteil in den Pyrrol-Comonomer-Mischungen 1 bis

2

25 Gew.%, bezogen auf die Monomer-Mischung. Als Comonomere kommen dabei insbesondere andere Heteroaromaten oder auch aromatische Verbindungen in Betracht. Als heteroaromatische Comonomere sind die an den C-Atomen substituierten Pyrrole, insbesondere die monoalkyl-, dialkyl-, monohalogen- oder dihalogen-substituierten Pyrrole zu nennen. Beispiele für substituierte Pyrrole sind die 3,4-Dialkylpyrrole, insbesondere mit 1 bis 4 C-Atomen im Alkylrest, wie 3,4-Dimethylpyrrol und 3,4-Diethylpyrrol, sowie auch die 3,4-Dihalogenpyrrole, wie das 3,4-Dichlorpyrrol. Weitere heteroaromatische Comonomeren sind insbesondere das Furan und Thiophen. Als aromatische Comonomere kommen vor allem die linear kondensierten, mehrkernigen Aromaten, wie Anthracen, Tetracen, Pentacen etc., in Betracht.

Unter Polypyrrolen werden im Rahmen dieser Erfindung dementsprechend Homopolymere des Pyrrols und Copolymere des Pyrrols verstanden.

Erfindungsgemäß wird die elektrochemische Polymerisation des Pyrrols bzw. der Comonomer-Mischungen des Pyrrols in Elektrolyt-Lösungsmittelsystemen durchgeführt, die überwiegend aus Wasser bestehen. Vorzugsweise findet als Elektrolyt-Lösungsmittel Wasser allein Einsatz. Zur Verbesserung der Dispergierbarkeit der Monomeren, insbesondere bei Mitverwendung von aromatischen Comonomeren, oder auch zur Verbesserung der Löslichkeit der verwendeten Leitsalze können dem Wasser auch untergeordnete Mengen an organischen Lösungsmitteln zugesetzt werden. Solche Lösungen von Wasser mit organischen Lösungsmitteln sollen zum Einsatz als Elektrolyt-Lösungsmittel in dem erfindungsgemäßen Verfahren zu mindestens 50 Gew.%, vorzugsweise zu mindestens 80 Gew.%, aus Wasser bestehen. Als organische Lösungsmittel für den Zusatz zu dem wäßrigen Elektrolyt-Lösungsmittel kommen insbesondere Alkohole, wie z. B. Methanol, Ethanol oder Diethylenglykol ; Ether, wie z. B. Tetrahydrofuran ; Ketone, wie z. B. Aceton ; Acetonitril, Dimethylformamid, Dimethylsulfoxid, Sulfolan, Propylencarbonat etc. in Betracht. Bevorzugt werden in dem erfindungsgemäßen Verfahren solche Elektrolyt-Lösungsmittel, die zu über 90 Gew.% aus Wasser bestehen, insbesondere Wasser selber. Außer den nachfolgend beschriebenen Leitsalzen enthalten die in dem erfindungsgemäßen Verfahren eingesetzten wäßrigen Elektrolyt-Lösungsmittel im allgemeinen keine weiteren Hilfs- oder Zusatzstoffe, wie z. B. Dispergiermittel, auch wenn der Zusatz solcher weiteren Hilfsstoffe grundsätzlich nicht ausgeschlossen ist.

Die Monomer-Konzentration wird in dem erfindungsgemäßen Verfahren im allgemeinen im Bereich von 0,001 bis 5 Mol, vorzugsweise von 0,01 bis 1 Mol Monomere pro Liter Elektrolyt-Lösungsmittel gehalten, kann jedoch auch unterhalb oder oberhalb dieser Grenzen liegen.

Als Leitsalz, das insbesondere dem Stromtransport während der anodischen Oxidation in dem Elektrolyt-Lösungsmittel dient, aber auch in dem erhaltenen Polymeren — wahrscheinlich in Komplex gebundener Form — enthalten ist und die Eigenschaften des Polymeren mit beeinflußt, werden erfindungsgemäß aromatische Sulfonsäuren und insbesondere die Salze von aromatischen Sulfonsäuren verwendet. Im allgemeinen eignen sich als Leitsalze in dem erfindungsgemäßen Verfahren die Verbindungen, bei denen das Abscheidungspotential des Sulfonsäure-Anions über etwa 0,8 bis 1 Volt, gemessen gegenüber der Standard-Kalomel-Elektrode, liegt. Die eingesetzten aromatischen Sulfonsäuren bzw. deren Salze sollen in dem wäßrigen Elektrolyt-Lösungsmittel löslich sein. Die Leitsalz-Konzentration beträgt dabei im allgemeinen 0,001 bis 1 Mol, vorzugsweise 0,01 bis 0,5 Mol, Leitsalz pro Liter Elektrolyt-Lösungsmittel.

Die erfindungsgemäß als Leitsalz einzusetzenden aromatischen Sulfonsäuren bzw. deren Salze können sich von den verschiedenartigsten mono- oder polyaromatischen Verbindungen ableiten und je nach aromatischem Grundgerüst eine oder mehrere Sulfonsäuregruppen enthalten. Als aromatische Grundverbindung können den erfindungsgemäß einzusetzenden aromatischen Sulfonsäuren bzw. deren Salzen Benzol kondensierte aromatische Kohlenwasserstoffe, wie z. B. Naphthalin, Anthracen oder Phenanthren ; die linear verknüpften, nicht kondensierten Oligo- oder Polyphenyle oder auch Derivate solcher aromatischen Kohlenwasserstoffe, wie z. B. Naphthochinon, Anthrachinon und höher kondensierte aromatische Chinone, zugrundeliegen. Die aromatischen Grundverbindungen können dabei neben den Sulfonsäure-Gruppen auch noch ein oder mehrere andere Substituenten enthalten, nämlich Halogenatome, OH-Gruppen, Nitro-Gruppen, unsubstituierte oder substituierte Aminogruppen oder Carboxyl-Gruppen. Die Anzahl der Sulfonsäure-Gruppen beträgt bei den aromatischen Sulfonsäure-Verbindungen im allgemeinen 1 bis 3.

Bevorzugt werden in dem erfindungsgemäßen Verfahren solche aromatischen Sulfonsäuren bzw. deren Salze als Leitsalze eingesetzt, die sich vom Benzol, Naphthalin, Anthracen, Phenanthren, Naphthochinon oder Anthrachinon ableiten. Als Beispiele für bevorzugt verwendete aromatische Sulfonsäuren seien genannt : Benzolsulfonsäure, Sulfosalicylsäure, p-Aminobenzolsulfonsäure, p-Hydroxybenzolsulfonsäure, N-Benzylamino-benzolksulfonsäure, durch OH-, Amino- und Nitro-Gruppen substituierte Benzolksulfonsäure, Naphthalinsulfonsäure, Naphthalindisulfonsäure, Naphthochinonsulfonsäure, Anthracensulfonsäure, Anthracendisulfonsäure, Anthrachinonsulfonsäure, Anthrachinondisulfonsäure, Phenanthrendisulfonsäure, und mit den oben genannten Gruppen substituierte Naphthalin-, Anthracen-, Naphthochinon- oder Anthrachinon-sulfonsäuren.

Als Kationen für die erfindungsgemäß einzusetzenden Leitsalze kommen neben den Erdalkalimetall-Kationen und $H^+$ insbesondere die Alkalimetall-Kationen, vorzugsweise $Li^+$, $Na^+$ oder $K^+$, in Betracht. Sehr günstig sind auch die $NO^+$- und $NO_2^-$-Kationen sowie insbesondere die Onium-Kationen, vor allem des Stickstoffs und des Phosphors, etwa des Typs $R_4N^+$ und $R_4P^+$, worin die Reste R, jeweils

3

unabhängig voneinander, Wasserstoff und/oder niedere Alkylreste, cycloaliphatische Reste oder aromatische Reste bedeuten. Unter den Onium-Kationen sind die tertiären und quaternären Ammonium- und die tertiären und quaternären Phosphonium-Kationen bevorzugt, besonders diejenigen, in denen sich die Reste R von Alkylresten mit 1 bis 6 C-Atomen ableiten.

Zusätzlich zu den aromatischen Sulfonsäuren bzw. deren Salzen können erfindungsgemäß auch noch andere übliche Leitsalze mitverwendet werden, wie beispielsweise Tetrafluoroborate, Hexafluoroarsenate, Hexafluoroantimonate, Hexachloroantimonate, Hexafluorophosphate, Perchlorate, Hydrogensulfate und Sulfate. Als Kationen für diese gegebenenfalls mitzuverwendenden üblichen Leitsalze kommen die oben angeführten Kationen, insbesondere die Alkalimetall-Kationen und die Onium-Kationen des Stickstoffs und des Phosphors, in Betracht. Der Anteil dieser neben den aromatischen Sulfonsäuren bzw. deren Salzen zusätzlich mitverwendeten üblichen Leitsalze soll maximal 50 Gew.%, bezogen auf die Summe aller eingesetzten Leitsalze, betragen. Vorzugsweise werden in dem erfindungsgemäßen Verfahren jedoch die aromatischen Sulfonsäuren bzw. insbesondere deren Salze als alleinige Leitsalze eingesetzt.

Das erfindungsgemäße Verfahren kann in den üblichen und an sich bekannten elektrolytischen Zellen oder Elektrolyse-Apparaturen durchgeführt werden. Gut geeignet sind beispielsweise einfache Elektrolyse-Apparaturen, bestehend aus einer Zelle ohne Diaphragma, zwei Elektroden und einer externen Stromquelle. Die Elektroden können dabei beispielsweise aus Graphit oder einem üblichen, inerten Elektrodenmaterial sein, insbesondere aus Edelmetall, wie Platin oder Palladium, Edelstahl, Nickel oder Titan. Da sich die gebildeten Polymeren auf der Anode ablagern, ist es für die Herstellung von filmförmigen Polypyrrolen zweckmäßig, wenn zumindest die Anode, insbesondere aber beide Elektroden, flächig ausgebildet sind. Die Größe der Anodenfläche entspricht dabei der Größe des resultierenden Polypyrrol-Films. Vorzugsweise sind die Flächen der beiden Elektroden parallel zueinander angeordnet.

Außer den erwähnten einfachen elektrolytischen Zellen ohne Diaphragma können auch andere Elektrolyseeinrichtungen für das erfindungsgemäße Verfahren Einsatz finden, beispielsweise Zellen mit Diaphragmen oder solche mit Referenzelektroden zur exakten Potentialbestimmung. Häufig ist eine Messung der Strommenge (A sec) zweckmäßig, da hierüber unter anderem die Schichtstärke der abgeschiedenen Filme kontrolliert werden kann.

Normalerweise wird das erfindungsgemäße Verfahren bei Raumtemperatur durchgeführt. Da sich die Reaktionstemperatur jedoch als unkritisch erwiesen hat, kann sie allerdings in einem breiten Bereich variiert werden, solange die Erstarrungstemperatur bzw. Siedetemperatur des Elektrolytlösungsmittels nicht unter- bzw. überschritten wird. Im allgemeinen hat sich eine Polymerisationstemperatur im Bereich von 0 bis 50 °C, insbesondere von + 10 bis + 30 °C, als sehr vorteilhaft erwiesen.

Als Stromquellen für den Betrieb der elektrolytischen Zelle, in der das erfindungsgemäße Verfahren durchgeführt wird, eignet sich jede Gleichstromquelle, wie z. B. eine Batterie, die eine hinreichend hohe elektrische Spannung liefert. Üblicherweise wird die erfindungsgemäße elektrochemische Polymerisation mit einer Spannung im Bereich von 0,1 bis 100 Volt, vorzugsweise im Bereich von 1,5 bis 25 Volt, betrieben. Für die Stromdichte haben sich bei dem erfindungsgemäßen Verfahren Werte im Bereich von 0,05 bis 20 mA/cm$^2$, vorzugsweise im Bereich von 1 bis 10 mA/cm$^2$, als günstig und vorteilhaft erwiesen.

Die Dauer der Elektrolyse hängt u. a. von dem verwendeten Elektrolyt-System, den jeweiligen Elektrolyse-Bedingungen sowie insbesondere auch von der gewünschten Filmdicke ab. Üblicherweise liegt die Elektrolysedauer im Bereich von 0,5 bis zu mehreren Stunden. So lassen sich beispielsweise ohne weiteres innerhalb einer Stunde Filme bis zu 70 μm Dicke erhalten, so daß sich beispielsweise in einem Zeitraum von einigen Stunden, beispielsweise von 2 bis 4 Stunden, Filme einer Dicke von mehr als 100 μm herstellen lassen.

Die während der Elektrolyse anodisch abgeschiedenen Polypyrrole werden zur Entfernung von anhaftendem Leitsalz mit Lösungsmitteln, vorzugsweise Wasser oder wäßrigen Lösungsmitteln, gewaschen und bei Temperaturen im Bereich von 25 bis 150 °C, vorzugsweise unter Vakuum, getrocknet. Bei Einsatz von inerten Elektroden, wie beispielsweise Edelmetall-, Stahl-, Titan-, Nickel- oder ähnlichen-Elektroden lassen sich danach die Filme der Polypyrrole im allgemeinen leicht von der Elektrode ablösen, vor allem, wenn Schichtstärken über 20 μm abgeschieden wurden. Die so erhaltenen Filme sind selbsttragend, stabil, haben gute mechanische Eigenschaften und Festigkeiten und eine gut ausgebildete Oberfläche.

Anstelle von selbsttragenden Filmen ist es gleichermaßen auch möglich, mit dem erfindungsmäßen Verfahren filmförmige Überzüge oder Schichten aus den Polypyrrolen im Verbund mit einem Substrat, beispielsweise einer Metallfolie oder einer Graphitschicht, herzustellen, indem man beispielsweise dieses Substrat als Anodenmaterial einsetzt und den hierauf abgeschiedenen Polypyrrol-Film nach der Elektrolyse auf dem Substrat beläßt. Hierbei können insbesondere auch Überzüge sehr geringer Schichtstärke z. B. im Bereich einiger μm erzeugt und so die Oberfläche des Substrats modifiziert werden.

Die erfindungsgemäß hergestellten filmförmigen Polypyrrole besitzen neben einer hohen elektrischen Leitfähigkeit im allgemeinen über 10$^{-2}$ Ω$^{-1}$ cm$^{-1}$, insbesondere über 10$^{-1}$ Ω$^{-1}$ cm$^{-1}$, sehr gute mechanische Eigenschaften und Stabilität gegen chemische oder physikalische Beanspruchung. Die elektrische Leitfähigkeit wird nach der Zweipunkt- oder Vierpunkt-Methode gemessen. Da die erfindungsgemäß hergestellten, p-leitenden Polypyrrole das Anion des bei ihrer Herstellung verwendeten Leitsalzes eingelagert enthalten, werden die Eigenschaften der erhaltenen Polypyrrole auch durch die Art des oder der verwendeten Leitsalze mitbestimmt. Sofern die elektrische Leitfähigkeit der erfindungsgemäß hergestellten Polypyrrole noch gesteigert oder verbessert werden soll, ist es durchaus möglich, diese in an sich bekannter Weise in der Gasphase oder in Lösung mit den üblichen Dotierungsmitteln, wie z. B. $AsF_5$, $SbF_5$, $SbCl_5$ etc., zu behandeln. Eine solche nachträgliche, zusätzliche Dotierung der erfindungsgemäß hergestellten Polypyrrole zur Erhöhung der elektrischen Leitfähigkeit ist jedoch im Normalfall nicht erforderlich. Polypyrrole, die aromatische Comonomeren mit eingebaut enthalten, können auch, am einfachsten elektrochemisch, vom p-leitenden System in ein n-leitendes System umgeladen werden.

Die erfindungsgemäß hergestellten Polypyrrole können mit Vorteil in allen bekannten und üblichen Anwendungsbereichen für Polypyrrole eingesetzt werden, wie z. B. zur Herstellung von Katalysatoren, elektrischen Schaltern, Halbleiter-Bauteilen, Elektroden, Abschirmmaterialien sowie zur antistatischen Ausrüstung von Kunststoffen.

Die Erfindung wird durch die nachfolgenden Beispiele näher erläutert. Die in den Beispielen angegebenen Teile und Prozente beziehen sich, sofern nicht anders vermerkt, auf das Gewicht.

Beispiel 1 bis 10

In allen Beispielen wurde in einer Durchflußelektrolysezelle (Inhalt 100 ml) gearbeitet. Als Elektroden dienten zwei Platinbleche, die im Abstand von 1,0 cm parallel zueinander befestigt waren. Jedes Platinblech war 1 mm stark und hatte eine polierte Oberfläche von 10 cm². Das Elektrolyt-System aus 1,84 g Pyrrol, 370 ml Wasser und 3,5 g des jeweiligen, in der nachfolgenden Tabelle angegebenen Leitsalzes wurde zur elektrochemischen Polymerisation durch die Elektrolysezelle gepumpt. Die Elektrolyse wurde bei Raumtemperatur mit einer Strommenge von 324 Coulomb und einer Stromdichte von 7,5 mA/cm² durchgeführt. Nach 20-minütiger Dauer wurde die Elektrolyse unterbrochen und der entstandene schwarze Polypyrrolfilm von der Anode abgelöst, gewaschen und getrocknet. In allen Fällen wurden mechanisch stabile Filme mit glatter und einheitlicher Oberfläche erhalten, deren elektrische Leitfähigkeitswerte ebenfalls in der nachfolgenden Tabelle angegeben sind.

Tabelle

| Beispiel | Leitsalz | | elektrische Leitfähigkeit |
|---|---|---|---|
| | Anion | Gegenion | $[\text{Ohm}^{-1}\text{cm}^{-1}]$ |
| 1 | (Naphthalin-SO₃⁻ Struktur) | $N(C_4H_9)_3H^+$ | 16,4 |
| 2 | $H_2N$-⟨O⟩-$SO_3^-$ | $N(C_4H_9)_3H^+$ | 0,2 |
| 3 | ⟨O⟩-$CH_2$-NH-⟨O⟩-$SO_3^-$ | $N(C_4H_9)_3H^+$ | 0,2 |
| 4 | ⟨O⟩-$SO_3^-$ | $N(C_4H_9)_3H^+$ | 28 |
| 5 | (Anthrachinon-SO₃⁻ Struktur) | $Na^+$ | 17 |
| 6 | (Phenol mit $O_2N$, $NH_2$, OH und $SO_3^-$ Struktur) | $Na^+$ | 0,6 |

Tabelle (Fortsetzung)

| Beispiel | Leitsalz | | elektrische Leitfähigkeit |
| | Anion | Gegenion | $[\text{Ohm}^{-1}\text{cm}^{-1}]$ |
|---|---|---|---|
| 7 | $O_2N$—⬡(—$SO_3^-$)(—$NO_2$)(—$NO_2$) | $K^+$ | 0,9 |
| 8 | $HO$—⬡(—$SO_3^-$)(—$COOH$) | $Na^+$ | 12 |
| 9 | $HO$—⬡—$SO_3^-$ | $N(C_2H_5)_3H^+$ | 15 |
| 10 | 2-(4-Sulfophenylazo)-chromotropsäure | $Na^+$ | 25 |

**Patentansprüche**

1. Verfahren zur Herstellung von Polypyrrolen durch anodische Oxidation von Pyrrol oder Mischungen von Pyrrol mit Comonomeren in einem wasserenthaltenden Elektrolyt-Lösungsmittel in Gegenwart von Leitsalzen unter Abscheiden der Polypyrrole an der Anode, dadurch gekennzeichnet, daß man die anodische Oxidation in einem wäßrigen Elektrolyt-Lösungsmittel durchführt, das zu mindestens 50 Gew.-% aus Wasser besteht, und Sulfonsäuren und/oder Salze der Sulfonsäuren des Benzol, kondensierter aromatischer Kohlenwasserstoffe, mehrkerniger Chinone, linear verknüpfter nicht kondensierter Oligo- oder Polyphenyle als Leitsalz enthält, wobei die vorgenannten aromatischen Grundverbindungen zusätzlich ein oder mehrere Halogen-, Hydroxyl-, Nitro-, unsubstituierte oder substituierte Amino-, Alkoxy- oder Carboxylsubstituenten aufweisen können.

2. Verfahren nach Anspruch 1, dadurch gekennzeichnet, daß das Elektrolyt-Lösungsmittel zu mindestens 80 Gew.-% aus Wasser besteht und insbesondere Wasser selber ist.

3. Verfahren nach einem der Ansprüche 1 oder 2, dadurch gekennzeichnet, daß als Leitsalz Alkalisalze der Sulfonsäuren verwendet werden.

4. Verfahren nach einem der Ansprüche 1 oder 2, dadurch gekennzeichnet, daß als Leitsalz Oniumsalze des Stickstoffs oder des Phosphors der Sulfonsäuren eingesetzt werden.

5. Verfahren nach einem der Ansprüche 1 bis 4, dadurch gekennzeichnet, daß neben den aromatischen Sulfonsäuren und/oder deren Salzen weitere übliche Leitsalze in einer Menge bis maximal 50 Gew.-%, bezogen auf die Gesamtmenge der eingesetzten Leitsalze, mitverwendet werden.

6. Verfahren nach einem der Ansprüche 1 bis 5, dadurch gekennzeichnet, daß eine Pyrrol/Comonomer-Mischung eingesetzt wird, die bis zu 25 Gew.-%, bezogen auf die gesamte Monomermischung, an Comonomeren enthält.

**Claims**

1. A process for the preparation of a polypyrrole by anodic oxidation of pyrrole or a mixture of pyrrole with comonomers in a water-containing electrolyte solvent in the presence of a conductive salt, with deposition of the polypyrrole on the anode, wherein the anodic oxidation is carried out in an aqueous electrolyte solvent which consists of not less than 50 % by weight of water and contains, as conductive salt, a sulfonic acid and/or a salt of a sulfonic acid of benzene, a condensed aromatic hydrocarbon, a polynuclear quinone or a linearly linked non-condensed oligophenyl or polyphenyl, the aforementioned aromatic parent compounds additionally optionally bearing one or more halogen, hydroxyl, nitro, unsubstituted or substituted amino, alkoxy or carboxyl substituents.

2. A process as claimed in claim 1, wherein the electrolyte solvent consists of not less than 80 % by weight of water, and in particular is water itself.

3. A process as claimed in claim 1 or 2, wherein the conductive salt used is an alkali metal salt of a sulfonic acid.

4. A process as claimed in claim 1 or 2, wherein the conductive salt used is a nitrogen or phosphorus onium salt of a sulfonic acid.

5. A process as claimed in any of claims 1 to 4, wherein, in addition to the aromatic sulfonic acid and/or a salt thereof, other conventional conductive salts are co-used in an amount of not more than 50 % by weight, based on the total amount of conductive salts employed.

6. A process as claimed in any of claims 1 to 5, wherein a pyrrole/comonomer mixture is employed which contains up to 25 % by weight, based on the total monomer mixture, of comonomers.

**Revendications**

1. Procédé de préparation de polypyrroles par une oxydation anodique du pyrrole ou de mélanges du pyrrole et de comonomères dans un solvant-électrolyte contenant de l'eau, en présence de sels conducteurs, les polypyrroles se déposant à l'anode, caractérisé en ce que l'oxydation anodique est réalisée dans un solvant-électrolyte aqueux avec une proportion d'eau d'au moins 50 % en poids, qui contient comme sel(s) conducteur(s) des acides sulfoniques et(ou) des sels d'acides sulfoniques du benzène, d'hydrocarbures aromatiques condensés, de quinones polycycliques ou d'oligo- ou de poly-phényles condensés, les composés aromatiques de base, énumérés ci-dessus, pouvant subsidiairement porter un ou plusieurs substituants halogène, hydroxyle, nitro, alcoxy, carboxyle ou amino non substitués ou substitués.

2. Procédé suivant la revendication 1, caractérisé en ce que le solvant-électrolyte contient une proportion d'eau d'au moins 80 % en poids ou est de l'eau.

3. Procédé suivant l'une des revendications 1 et 2, caractérisé en ce que des sels de métaux alcalins d'acides sulfoniques sont utilisés comme sel(s) conducteur(s).

4. Procédé suivant l'une des revendications 1 et 2, caractérisé en ce que le sel conducteur est un sel d'onium de l'azote ou du phosphore des acides sulfoniques.

5. Procédé suivant l'une des revendications 1 à 4, caractérisé en ce que, à côté des acides sulfoniques aromatiques et(ou) des sels de ceux-ci, on emploie d'autres sels conducteurs usuels en une proportion ne dépassant pas 50 % du poids total des sels conducteurs utilisés.

6. Procédé suivant l'une des revendications 1 à 5, caractérisé en ce que l'on emploie un mélange de pyrrole et de comonomère(s), dans lequel les comonomères constituent jusqu'à 25 % du poids total des monomères.